# EUROPEAN PATENT APPLICATION

(11) **EP 4 687 281 A1**
(43) Date of publication of application: **04.02.2026**
(21) Application number: 25180397.9
(22) Date of filing: 03.06.2025
(51) Int. Cl.: H02M 7/5387, H02M 7/5395, H02M 7/00, H02M 1/12, H02M 1/14, H02P 27/06, H05K 7/14, H01F 27/24, H01R 25/16, H02G 5/00

(54) **ELECTRIC POWER CONVERSION DEVICE**

(30) Priority: 30.07.2024 KR 20240101044
(71) Applicant: Hyundai Motor Company, Seoul 06797 (KR); Kia Corporation, Seoul 06797 (KR)
(72) Inventor: YOON, Jae Hoon, 18280 Gyeonggi-do (KR); KIM, Yun Ho, 18280 Gyeonggi-do (KR)
(74) Representative: Hoffmann Eitle

(57) **Abstract**

Disclosed is an electric power conversion device including an input port configured such that external power is input thereto through input terminals, and an input port cover provided at one end of the input port to seal the end of the input port and including a bus bar having one end in contact with the input terminals and a remaining end grounded, and capacitors provided between the end and the remaining end of the bus bar.

## Description

### TECHNICAL FIELD

The present disclosure relates to an electric power conversion device.

### BACKGROUND

Electromagnetic compatibility (EMC) refers to the ability to perform functions (e.g., perfectly) while complying with the allowable range of electromagnetic interference with the surrounding environment. Since electric power conversion devices used in electric vehicles include high-frequency switching circuits, problems related to EMC may occur, and some countries have regulations related to EMC.

Particularly, in relation to filtering of the high-frequency range, a filter configuration that may (e.g., effectively) filter a high-frequency band while maintaining the size of a power conversion device is useful.

The matters described in this Background section are (e.g., only) for enhancement of understanding of the background of the disclosure, and should not be taken as acknowledgement that they correspond to prior art already known to those skilled in the art.

### SUMMARY

Therefore, the present disclosure has been made in view of the above problems, and it is an object of the present disclosure to provide a filter that may (e.g., effectively) filter a high-frequency band while substantially maintaining the size of an electric power conversion device by providing capacitors in an input port cover applied to an input port of the electric power conversion device.

Technical problems to be achieved in the present disclosure are not limited to the technical problems mentioned above, other technical problems not mentioned may be (e.g., clearly) understood by those skilled in the art to which the present disclosure pertains from the following description.

In accordance with an aspect of the present disclosure, the above and other objects can be accomplished by the provision of an electric power conversion device including an input port configured such that external power is input thereto through input terminals, and an input port cover provided at one end of the input port to seal the end of the input port and includes a bus bar having one end in contact with the input terminals and a remaining end grounded, and capacitors provided between the end and the remaining end of the bus bar.

The bus bar of the input port cover may include high-voltage bus bars and ground bus bars, and the input port may further include a cover housing configured to surround a part of the bus bar.

A sealing member configured to seal the input port may be provided outside the cover housing.

A recessed groove may be formed in (e.g., each of) ends of the high-voltage bus bars and the ground bus bars so that (e.g., each of) the capacitors is electrically connected to a corresponding one of the high-voltage bus bars and a corresponding one of the ground bus bars therethrough.

Two or more high-voltage bus bars may be provided, and the cover housing may be provided with receiving spaces configured to accommodate the capacitors in equal number to the high-voltage bus bars.

An end (e.g., of each) of the high-voltage bus bars may be partially bent to form a contact part configured to come into contact with a corresponding one of the input terminals.

The input terminals may be electrically connected to P and N terminals or P, N, and n terminals of the electric power conversion device through bolts, and ends of the high-voltage bus bars may come into contact with ends of the input terminals or bolt heads.

The cover housing may be formed by insert injection molding.

The cover housing may be provided with a protrusion configured to protrude and be inserted into the end of the input port, and receiving spaces configured to accommodate the capacitors may be provided in the protrusion.

First fastening holes may be formed at corners of the end of the input port, second fastening holes may be formed at corners of the cover housing, and the input port cover may be fastened to the end of the input port by bolts configured to pass through the first fastening holes and the second fastening holes.

The ground bus bars may be provided such that ends thereof surround peripheries of the second fastening holes, and the input terminals may be grounded by contact between the ends of the ground bus bars and peripheries of the first fastening holes.

When the input port cover is fastened to the end of the input port, one end of the bus bar may be electrically connected to the input terminals.

The input terminals may be electrically connected to P and N terminals or P, N, and n terminals of the electric power conversion device, and the electric power conversion device may further include a core fixed within the electric power conversion device and formed in a shape configured to surround the P and N terminals or the P, N, and n terminals of the electric power conversion device.

The bus bar of the input port cover may include high-voltage bus bars and ground bus bars, the high-voltage bus bars may come into contact with the input terminals, and the ground bus bars may come into contact with a housing of electric power conversion device.

The capacitors may be Y-capacitors.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a filter circuit diagram of an electric power conversion device;
FIG. 2 is a perspective view of the electric power conversion device;
FIG. 3 illustrates an input port of the electric power conversion device;
FIG. 4 illustrates an input port cover that seals the end of the input port;
FIG. 5 is a cross-sectional view of the input port (taken along line A-A of FIG. 2);
FIG. 6 illustrates a bus bar of the input port cover; and
FIG. 7 illustrates a cover housing.

### DETAILED DESCRIPTION

Hereinafter, embodiments disclosed in the present disclosure will be described in detail, and the same or similar components in different drawings will be indicated by the same reference numerals and redundant descriptions thereof will be omitted.

In the following description of the embodiments disclosed in the present disclosure, a detailed description of known functions and configurations incorporated herein will be omitted when it may make the subject matter of the present disclosure rather unclear. In addition, the accompanying drawings are (e.g., only) for easy understanding of the embodiments disclosed in this specification, and the technical idea disclosed in this specification is not limited by the accompanying drawings and should be understood to include (e.g., all) changes, equivalents or substitutes included in the spirit and technical scope of the present disclosure.

In the following description of the embodiments, terms, such as "first" and "second", may be used to describe various elements but do not limit the elements. These terms are used (e.g., only) to distinguish one element from other elements.

Singular expressions may encompass plural expressions, unless they have clearly different contextual meanings.

In the following description of the embodiments, terms, such as "including", "comprising" and "having", are to be interpreted as indicating the presence of characteristics, numbers, steps, operations, elements or parts stated in the description or combinations thereof, and do not exclude the presence of one or more other characteristics, numbers, steps, operations, elements, parts or combinations thereof, or possibility of adding the same.

The suffixes "module" and "part" for components used in the following description are given or used interchangeably (e.g., only) for ease of preparing the specification, and do not have distinct meanings or roles in themselves.

When an element or layer is referred to as being "connected to" or "coupled to" another element or layer, it may be (e.g., directly) connected to or coupled to the other element or layer, or intervening elements or layers may be present. In contrast, when an element is referred to as being "directly connected to" or "directly coupled to" another element or layer, there may be no intervening elements or layers present.

Due to the above-described problems, it may be useful (e.g., is necessary) to add a noise filter element in an electric power conversion device to improve high-frequency band performance. In general, if the noise filter element is mounted in the electric power conversion device, the electric power conversion device is expected to have an increased size. That is, since a separate space for mounting the noise filter element is (e.g., must be) formed, the size of the electric power conversion device (e.g., inevitably) increases.

Particularly, a PI filter may be provided to improve the performance in the high-frequency band, and the PI filter includes a core that surrounds P and N terminals (when multi-charging is not applied) or P, N, and n terminals (when multi-charging is applied) of the electric power conversion device and an additional high-frequency filtering capacitor.

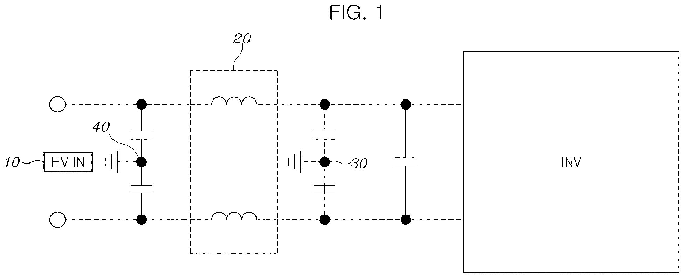

FIG. 1 is a filter circuit diagram of an electric power conversion device. External power from an external power supply 10 is input to an input port of the electric power conversion device. A filter may be configured on the input port side to improve high-frequency or low-frequency band performance. FIG. 1 illustrates a PI filter to improve the high-frequency band performance.

Since the PI filter is configured such that a core 20 that surrounds P and N terminals or P, N, and n terminals of the electric power conversion device is located between a low-frequency band filtering capacitor (Y-CAP) 30 and a high-frequency band filtering capacitor (Y-CAP) 40, the PI filter may be (e.g., is) difficult to construct compared to an LC filter in which a low-frequency filtering capacitor and a high-frequency filtering capacitor are provided adjacent (e.g., to each other).

The core 20 is provided to be fixed to the inside of the electric power conversion device. Here, the core may be a CM core, the core may be formed in a ring shape so as to surround the P and N terminals or the P, N, and n terminals to provide inductance, and a noise component generated from the P and N terminals or the P, N, and n terminals may be removed by the corresponding inductance.

Meanwhile, there is a limit to a noise frequency band that may be removed through the core 20, and a separate structure (electrical connection and grounding) is used (e.g., required) to construct the high-frequency filtering capacitor 40. Accordingly, a method of (e.g., effectively) accommodating the capacitor without increasing the size of the electric power conversion device is useful (e.g., required).

In order to (e.g., effectively) configure a PI filter that filters a high-frequency band, the present disclosure suggests an input port cover that may accommodate capacitors. Specifically, the electric power conversion device according to the present disclosure includes an input port 100 configured such that external power is input thereto through input terminals 110, and an input port cover 300 provided at one end of the input port 100 to seal the end of the input port 100 and including a bus bar 310 provided with one end that is in contact with the input terminals 110 and the other end that is grounded, and capacitors 330 provided between the end and the other end of the bus bar 310.

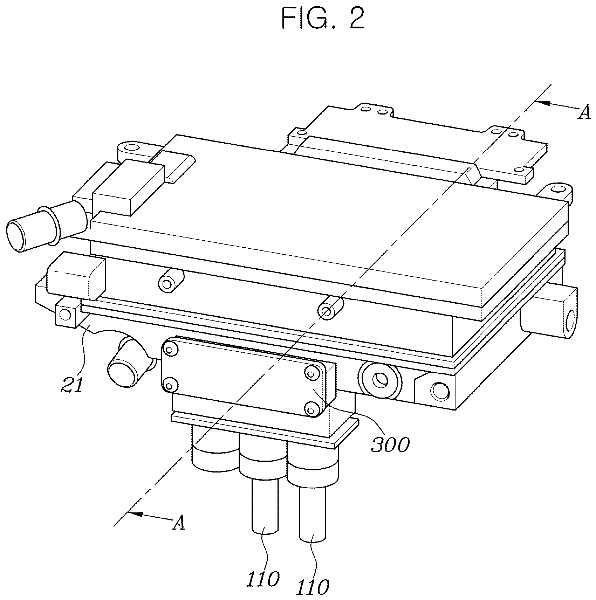

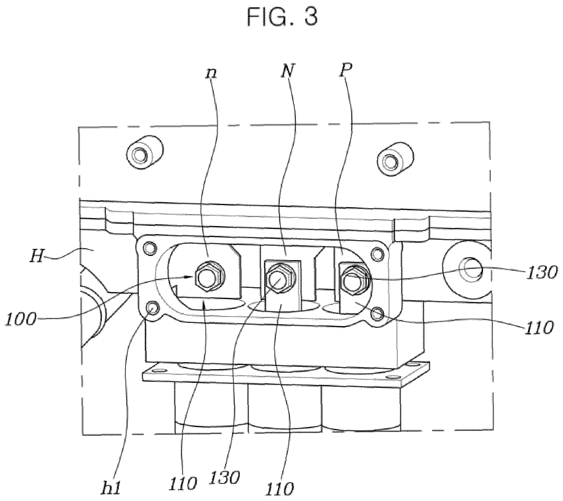

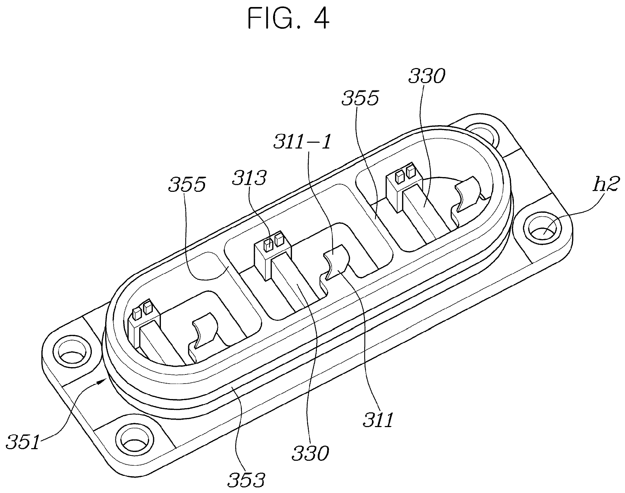

FIG. 2 is a perspective view of the electric power conversion device, FIG. 3 illustrates an input port of the electric power conversion device, and FIG. 4 illustrates an input port cover that seals the end of the input port.

Referring to FIGS. 2 to 4, the electric power conversion device may be an inverter for converting DC to AC, and the external power corresponding to DC may be input to the inverter through the input port 100. The input terminals 110 are electrically connected to P and N terminals P and N or P, N, and n terminals P, N, and n of the inverter to input the external power to the inverter.

Particularly, the input terminals 110 are electrically connected to the P and N terminals of the inverter by bolts 130. Referring to FIG. 3, one end of the input port 100 is open, and when the input terminals 110 are inserted into the inverter, the bolts 130 are inserted into the open end of the input port 100 so that the input terminals 110 may be electrically connected to the P and N terminals or the P, N, and n terminals of the inverter.

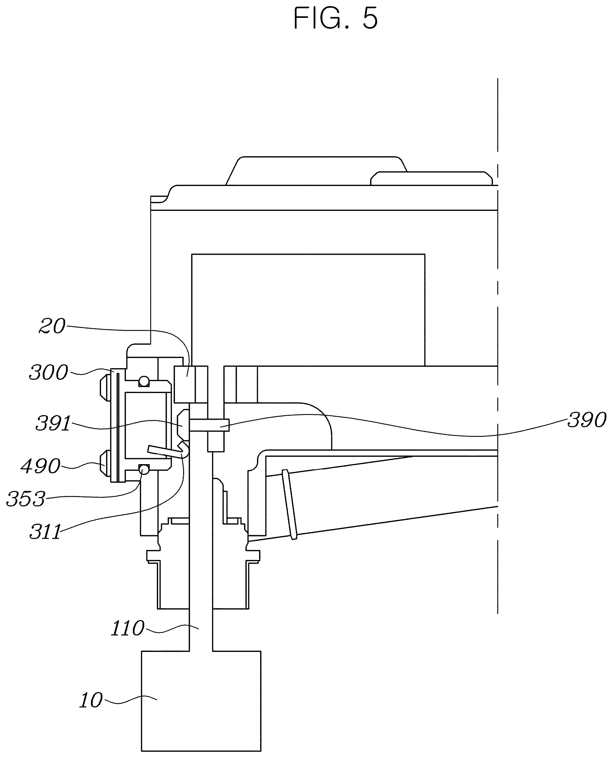

FIG. 5 is a cross-sectional view of the input port (taken along line A-A of FIG. 2). Referring to FIG. 5, a PI filter is formed by the core 20 that surrounds the P and N terminals or the P, N, and n terminals, and the capacitors 330 provided in the input port cover 300.

When the electrical connection between the input terminals 110 and the P and N terminals or the P, N, and n terminals has been completed, the input port cover 300 is fastened to the end of the input port 100 to seal the electric power conversion device.

The present disclosure provides the capacitors 330 configured to improve high-frequency band performance in the input port cover 300 and provides separate spaces for the capacitors 330 in the input port cover 300, thereby being capable of (e.g., effectively) configuring the PI filter without increasing the size of the electric power conversion device.

Specifically, the input port cover 300 includes the bus bar 310. The bus bar 310 is configured such that one end thereof is in contact with the input terminals 110 and the other end thereof is grounded with a housing H of the electric power conversion device, and the capacitors 330 are provided with the end and the other end of the bus bar 310 to ground filtered current, thereby being capable of improving high-frequency band electromagnetic wave filtering performance.

That is, the capacitors 330 are provided in the input port cover 300, and one end (e.g., of each) of the capacitors 330 is connected to a corresponding one of the P and N terminals or the P, N, and n terminals through the bus bar 310 of the input port cover 300, and the other end (e.g., of each) of the capacitors 330 is connected to the housing H of the electric power conversion device, thereby being capable of performing high-frequency band electromagnetic wave filtering.

Specifically, to explain the configuration of the input port cover 300, the input port cover 300 may include a cover housing 350 that surrounds a part of the bus bar 310.

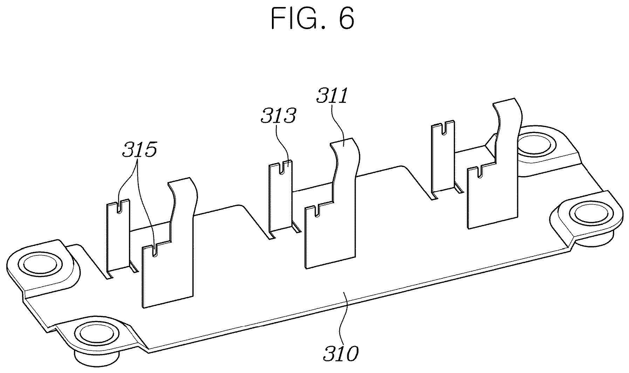

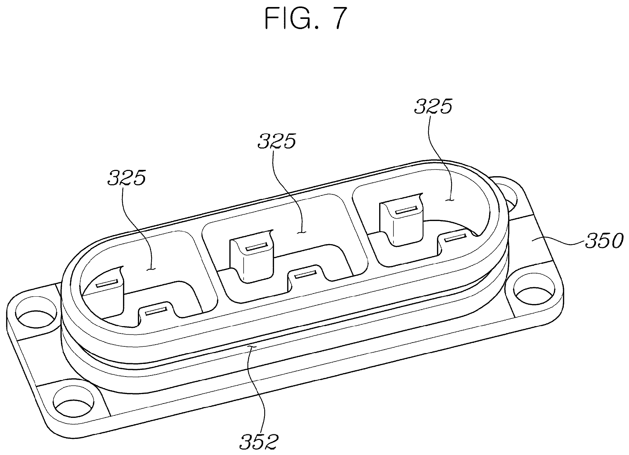

More specifically, the bus bar 310 of the input port cover 300 may include high-voltage bus bars 311 and ground bus bars 313. FIG. 6 illustrates the bus bar of the input port cover, and FIG. 7 illustrates the cover housing. Referring to FIGS. 4, 6, and 7, the input port cover 300 is formed by inserting the bus bar 310 into an injection mold and then performing injection molding using a thermoplastic resin. That is, the cover housing 350 is formed by insert injection molding.

Thereby, a part of the bus bar 310 is surrounded by the cover housing 350. However, the ends of high-voltage bus bars 311 may protrude to come into contact with the input terminals 110 and be electrically connected to the capacitors 330, and a part (e.g., of each) of the ends of the ground bus bars 313 may also protrude to be electrically connected to a corresponding one of the capacitors 330. That is, the cover housing 350 is formed by insert injection molding so that a part of the end of the bus bar 310 protrudes.

The input port cover 300 formed as described above is shown in FIG. 4, and when the input port cover 300 is fastened to the end of the input port 100 of the electric power conversion device, the exposed ends of the high-voltage bus bars 311 may come into contact with the input terminals 110 connected to the P and N terminals or the P, N, and n terminals.

Further, after the capacitors 330 are electrically connected to the bus bar 310, the cover housing 350 may be molded with epoxy or silicone to fix the capacitors 330.

Here, two or more high-voltage bus bars 311 may be formed, and (e.g., each) high-voltage bus bar 311 may basically come into contact with a corresponding one of the input terminals 110 connected to the P and N terminals, or in some cases, may come into contact with the n terminal that is additionally provided.

In order to filter electromagnetic waves of the high frequency band generated when external power is input to the P and N terminals or the P, N, and n terminals, the ends of the high-voltage bus bars 311 may extend in the lengthwise direction, and a part (e.g., of each) of the ends of the high-voltage bus bar 311 may be bent to form a contact part 311-1 that comes into contact with a corresponding one of the input terminals 110. Since the contact part 311-1 of the high-voltage bus bar 311 is bent, the cross-sectional area of the high-voltage bus bar 311 electrically connected to the input terminal 110 may be large, and robustness against vibration may be secured to facilitate electrical connection between the input terminal 110 and the high-voltage bus bar 311.

Here, the contact part 311-1 may come into contact with the end of the input terminal 110, or may come into contact with a head 391 of the bolt 390 that electrically connects the input terminal 110 and the P or N terminal or the P, N, or n terminal.

Although an embodiment in which an electrical connection with the input terminals 110 through the bus bar 310 is performed has been described, another embodiment in which an electrical connection with the input terminals 110 through coil spring-type members is performed is also possible. If the coil spring-type members are used, more vibration-resistant performance may be expected.

First fastening holes h1 are formed at corners of one end of the input port 100. In addition, second fastening holes h2 are formed at corners of the cover housing 350. When the input port cover 300 is fastened to the end of the input port 100, the first fastening holes h1 and the second fastening holes h2 correspond to each other. Thereafter, the input port cover 300 may be fastened to the end of the input port 100 by bolts 490 passing through the first fastening holes h1 and the second fastening holes h2.

Here, the ground bus bars 313 are provided such that the ends thereof surround the peripheries of the second fastening holes h2. That is, the ends of the ground bus bars 313 are designed so that the resin is not injected, and thereby, the ends of the ground bus bars 313 are exposed. Accordingly, the input terminals 110 may be grounded by contact between the first fastening holes h1 of the end of the input port 100 and the ends of the ground bus bars 313. That is, the ends of the ground bus bars 313 may come into contact with the housing H of the electric power conversion device and be grounded.

Particularly, the capacitors 330 may be provided between the high-voltage bus bars 311 and the ground bus bars 313 to filter high-frequency band electromagnetic waves, and receiving spaces 320 configured to accommodate capacitors 330 corresponding in number to the high-voltage bus bars 311 (or corresponding in number to the P and N terminals or the P, N, and n terminals of the electric power conversion device) may be provided in the cover housing 350.

More specifically, the cover housing 350 may be provided with a protrusion 351 inserted into the open end of the input port 100. In addition, the receiving spaces 325 configured to accommodate the capacitors 330 may be provided in the protrusion 351. The receiving spaces 325 are provided in a (e.g., equal) number to correspond to the high-voltage bus bars 311, and the receiving spaces 325 in which the capacitors 30 are accommodated are physically separated from each other by wall surfaces 355 formed in the protrusion 351.

The capacitors 330 are Y-capacitors (Y-CAP), and one end (e.g., of each) of the capacitors 330 is connected to the end of a corresponding one of the high-voltage bus bars 311, and the other end (e.g., of each) of the capacitors 330 is connected to the end of a corresponding one of the ground bus bar 313. Particularly, a recessed groove 315 is formed in the ends of the high-voltage bus bars 311 and the ground bus bars 313, and the capacitors 330 may be electrically connected to the high-voltage bus bars 311 and the ground bus bars 313 by fastening the respective ends of the capacitors 330 to the recessed grooves 315 of the high-voltage bus bars 311 and the ground bus bars 313.

The cover housing 350 may be injection molded such that a part thereof is exposed so as to facilitate coupling between the recessed grooves 315 of the high-voltage bus bars 311 and the ground bus bars 313 and the capacitors 330.

Further, a sealing member 353 configured to seal the input port 100 may be provided outside the cover housing 350. The electric power conversion device uses sensitive electronic components and electronic materials, and if outdoor air containing moisture or foreign substances are introduced into the electric power conversion device, corrosion of the electronic components or short circuit may occur, and therefore, sealing is useful (e.g., essential).

Particularly, sealing of the input port 100 to which high voltage and/or high current is input is useful (e.g., very important) in terms of efficiency of the electric power conversion device. Accordingly, a mounting groove 352 in which the sealing member 353 is provided may be formed on the outer surface of the protrusion 351 of the cover housing 350.

The sealing member 353 may be formed of an elastic material, and may be an O-ring as a representative example. The sealing member 353 may (e.g., effectively) prevent foreign substances or outdoor air from being introduced into the electric power conversion device, thereby being capable of preventing durability of the electric power conversion device from being reduced and enabling the electric power conversion device to (e.g., continuously) exhibit the same performance.

As is apparent from the above description, the present disclosure provides an electric power conversion device that may (e.g., effectively) filter a high-frequency band while maintaining the size of the electric power conversion device by providing capacitors in an input port cover applied to an input port of the electric power conversion device to perform a sealing function.

Effects obtained by the present disclosure are not limited to the effects mentioned above, and other effects not mentioned may be clearly understood by those skilled in the art to which the present disclosure pertains from the above description.

While the present disclosure has been explained in relation to specific embodiments, it is to be understood that various modifications and changes thereof will become apparent to those skilled in the art without departing from the technical spirit of the present disclosure as provided by the appended claims.

## Claims

1. An electric power conversion device comprising:
an input port configured such that external power is input thereto through input terminals; and
an input port cover provided at one end of the input port to seal the end of the input port and comprising a bus bar having one end in contact with the input terminals and a remaining end grounded, and capacitors provided between the end and the remaining end of the bus bar.

2. The electric power conversion device of claim 1, wherein:
the bus bar of the input port cover comprises high-voltage bus bars and ground bus bars; and
the input port further comprises a cover housing configured to surround a part of the bus bar.

3. The electric power conversion device of claim 2, wherein a sealing member configured to seal the input port is provided outside the cover housing.

4. The electric power conversion device of claim 2, wherein a recessed groove is formed in each of ends of the high-voltage bus bars and the ground bus bars so that each of the capacitors is electrically connected to a corresponding one of the high-voltage bus bars and a corresponding one of the ground bus bars therethrough.

5. The electric power conversion device of claim 2, wherein:
two or more high-voltage bus bars are provided; and
the cover housing is provided with receiving spaces configured to accommodate the capacitors in equal number to the high-voltage bus bars.

6. The electric power conversion device of claim 2, wherein an end of each of the high-voltage bus bars is partially bent to form a contact part configured to come into contact with a corresponding one of the input terminals.

7. The electric power conversion device of claim 2, wherein:
the input terminals are electrically connected to P and N terminals or P, N, and n terminals of the electric power conversion device through bolts; and
the end of each of the high-voltage bus bars come into contact with the end of one of the input terminals or bolt heads.

8. The electric power conversion device of claim 2, wherein the cover housing is formed by insert injection molding.

9. The electric power conversion device of claim 2, wherein the cover housing is provided with a protrusion configured to protrude and be inserted into the end of the input port, and receiving spaces configured to accommodate the capacitors are provided in the protrusion.

10. The electric power conversion device of claim 9, wherein:
first fastening holes are formed at at least one corner of the end of the input port; and
second fastening holes are formed at at least one corner of the cover housing, and the input port cover is fastened to the end of the input port by bolts configured to pass through the first fastening holes and the second fastening holes.

11. The electric power conversion device of claim 10, wherein the ground bus bars are provided such that ends thereof surround peripheries of the second fastening holes, and the input terminals are grounded by contact between the ends of the ground bus bars and peripheries of the first fastening holes.

12. The electric power conversion device of claim 1, wherein, when the input port cover is fastened to the end of the input port, one end of the bus bar is electrically connected to the input terminals.

13. The electric power conversion device of claim 1, wherein:
the input terminals are electrically connected to P and N terminals or P, N, and n terminals of the electric power conversion device; and
the electric power conversion device further comprises a core fixed within the electric power conversion device and formed in a shape configured to surround the P and N terminals or the P, N, and n terminals of the electric power conversion device.

14. The electric power conversion device of claim 1, wherein the bus bar of the input port cover comprises high-voltage bus bars and ground bus bars,
wherein the high-voltage bus bars come into contact with the input terminals, and the ground bus bars come into contact with a housing of the electric power conversion device.

15. The electric power conversion device of claim 1, wherein the capacitors are Y-capacitors.
